# EUROPÄISCHE PATENTSCHRIFT

(11) **EP 0 750 002 B1**
(45) Veröffentlichungstag und Bekanntmachung des Hinweises auf die Patenterteilung: **25.08.1999**
(21) Anmeldenummer: 96109272.3
(22) Anmeldetag: 10.06.1996
(51) Int. Cl.: C08G 69/26, C08G 69/32, C08G 69/04, C08G 73/22, G03F 7/023

(54) **Verfahren zur Herstellung von Poly-o-hydroxyamiden**
Process for the preparation of poly-o-hydroxy amides
Procédé de préparation de poly-o-hydroxy amides

(30) Priorität: 19.06.1995 DE 19522158
(43) Veröffentlichungstag der Anmeldung: 27.12.1996
(73) Patentinhaber: SIEMENS AKTIENGESELLSCHAFT, 80333 München (DE)
(72) Erfinder: Sezi, Recai, Dr., 91341 Röttenbach (DE); Ahne, Hellmut, Dr., 91341 Röttenbach (DE); Gestigkeit, Roland, 90478 Nürnberg (DE)

(56) Entgegenhaltungen:
- EP-A- 0 158 726
- EP-A- 0 264 678
- EP-A- 0 291 779
- GB-A- 1 142 071

## Beschreibung

Die Erfindung betrifft ein Verfahren zur Herstellung von Poly-o-hydroxyamiden durch Umsetzung einer Dicarbonsäure mit einem Bis-o-aminophenol.

In der Mikroelektronik werden hochwärmebeständige Polymere benötigt, insbesondere als Schutz- und Isolierschichten bzw. als Dielektrika (siehe dazu beispielsweise: "SAMPE Journal", Vol. 25 (1989), No. 6, Seiten 18 bis 23, und "Proceedings of the 1992 International Conference on Multichip Modules", Seiten 394 bis 400). Einige der verwendeten Polymere, beispielsweise Homo- und Copolymere aromatischer Polyether sowie Vorstufen von Polyimiden (PI) und Polybenzoxazolen (PBO), weisen eine gute Löslichkeit in organischen Lösungsmitteln und gute Filmbildungseigenschaften auf und können mittels Schleudertechnik auf elektronische Bauteile aufgebracht werden (siehe dazu beispielsweise: "High Performance Polymers", Vol. 4 (1992), No. 2, Seiten 73 bis 80, und "Polymers for Advanced Technologies", Vol. 4 (1993), Seiten 217 bis 233). Polymer-Vorstufen der genannten Art werden durch eine Temperaturbehandlung cyclisiert, d.h. in die entsprechenden Polymere (PI bzw. PBO) umgewandelt; dabei ergeben sich die endgültigen Eigenschaften.

PI- und PBO-Vorstufen können, beispielsweise durch Zusatz geeigneter photoaktiver Komponenten, auch photosensitiv eingestellt und dadurch direkt, d.h. ohne die Verwendung eines Hilfsresists, strukturiert werden. Bei der Verwendung alkalilöslicher Vorstufen ergibt sich bei photosensitiven PBO-Vorstufen - im Vergleich mit den meisten photosensitiven PI-Vorstufen - der Vorteil einer Strukturierbarkeit im positiven Modus und die Möglichkeit einer wäßrig-alkalischen Entwicklung (siehe dazu: EP-PS 0 023 662, EP-OS 0 264 678 und EP-PS 0 291 779). Der dabei angewendete photolithographische Prozeß ist, bis auf die Cyclisierung, der gleiche wie bei der Strukturierung bekannter Positivresists auf der Basis von Novolaken und Chinonaziden, eines weltweit in zahlreichen Fertigungslinien eingesetzten Prozesses (siehe dazu beispielsweise: D.S. Soane und Z. Martynenko "Polymers in Microelectronics - Fundamentals and Applications", Elsevier, Amsterdam 1989, Seiten 77 bis 124).

Die gängigste Methode zur Herstellung von alkalilöslichen PBO-Vorstufen, d.h. von Poly-o-hydroxyamiden, ist die Umsetzung eines Dicarbonsäurechlorids mit einem geeigneten Bis-o-aminophenol. Zum Abfangen des bei der Reaktion entstehenden Chlorwasserstoffs wird in der Regel eine lösliche Base, wie Pyridin, zugesetzt (siehe: EP-OS 0 264 678 und EP-PS 0 291 779). Eine gute Alkalilöslichkeit ist eine wichtige Voraussetzung für die Verwendbarkeit der PBO-Vorstufen als Basispolymer für ein wäßrig-alkalisch entwickelbares photosensitives Dielektrikum. Für mikroelektronische Anwendungen müssen die Vorstufen in metallionenfreien Entwicklern löslich sein, damit derartige Entwickler auch bei der Photostrukturierung verwendet werden können.

Ein großer Nachteil des Herstellungsverfahrens mittels Dicarbonsäurechloriden besteht darin, daß diese Säurechloride in einem gesonderten Prozeß aus den entsprechenden Säuren hergestellt werden müssen, weil die Säurechloride der überwiegenden Anzahl der Dicarbonsäuren kommerziell nicht erhaltlich sind. Die zusätzliche Synthese eines Dicarbonsaurechlorids verursacht aber erhebliche Mehrkosten. Dies gilt prinzipiell auch für andere aktive Dicarbonsäurederivate, beispielsweise Ester.

Zur Synthese von Poly-o-hydroxyamiden ist es auch bekannt, das Bis-o-aminophenol in Gegenwart eines Carbodiimids mit der Dicarbonsäure umzusetzen (siehe: EP-OS 0 158 726). Bei dieser Reaktion bereiten jedoch Harnstoffreste, die aufgrund einer Umlagerungsreaktion am Harz verbleiben, oft Probleme. Sie beeinträchtigen nämlich die thermische Beständigkeit des Polybenzoxazols sowie die Qualität der daraus hergestellten Schichten.

Ein alternatives Herstellungsverfahren für Poly-o-hydroxyamide besteht darin, die Umsetzung der Dicarbonsäure mit dem Bis-o-aminophenol unter Verwendung eines Kondensationsreagenz wie 1-Ethoxycarbonyl-2-ethoxy-1,2-dihydrochinolin und 1,1'-Carbonyldioxy-di-1,2,3-benzotriazol durchzuführen (siehe: EP-OS 0 391 196). Die auf diese Weise hergestellten Polymere besitzen aber keine ausreichende Löslichkeit in wäßrig-alkalischen Entwicklern, insbesondere in metallionenfreien Entwicklern.

Es sind auch Verfahren bekannt, bei denen die Amidbildung mittels Phosphorverbindungen erfolgt (siehe dazu: EP-OS 0 481 402, US-PS 4 331 592 und DE-OS 37 16 629). Bei Poly-o-hydroxyamiden führen derartige Synthesen aber entweder direkt zu cyclisierten, d.h. alkaliunlöslichen Produkten oder im Polymer verbleiben phosphorhaltige, teilweise auch chemisch gebundene Reste, wodurch das Polymer, wegen der Dotierungseigenschaften von Phosphor, für mikroelektronische Anwendungen unbrauchbar wird. Im Gegensatz zu ionischen Verunreinigungen können nämlich derartige Reste beispielsweise nicht mittels Ionenaustauschern entfernt werden.

Es fehlt somit an einem universellen Verfahren zur Herstellung von alkalilöslichen Poly-o-hydroxyamiden, bei dem - anstelle von Dicarbonsäurechloriden bzw. anderen aktiven Dicarbonsäurederivaten - direkt die Dicarbonsäuren eingesetzt werden können. Ein solches Verfahren muß auch die Forderung erfüllen, daß die Carboxylgruppen der Dicarbonsäure mit den Aminogruppen des Bis-o-aminophenols reagieren (unter Amidbildung), nicht aber mit dessen - für die Alkalilöslichkeit des Poly-o-hydroxyamids erforderlichen - Hydroxylgruppen (unter Esterbildung), d.h. die Reaktionsselektivität der Amidbildung muß - gegenüber der Esterbildung - groß sein. Kann nämlich die Esterbildung nicht ausgeschlossen bzw. nicht ausreichend genug unterdrückt werden, so führt sie zur Verschlechterung der Alkalilöslichkeit und des Cyclisierungsverhaltens des hergestellten Poly-o-hydroxyamids. Ferner kann eine geringe Reaktionsselektivitat zu einer Gelbildung in der Polymerlösung führen, wodurch das Poly-o-hydroxyamid unbrauchbar wird.

Aufgabe der Erfindung ist es, ein vereinfachtes und kostengünstiges Verfahren zur Herstellung von alkalilöslichen Poly-o-hydroxyamiden anzugeben, welches die Synthese dieser Polymere aus einer Dicarbonsäure und einem Bis-o-aminophenol ohne zusätzliche Herstellung eines aktiven Dicarbonsäurederivates erlaubt.

Dies wird erfindungsgemaß dadurch erreicht, daß
(a) die Dicarbonsäure zusammen mit einem Sulfonsäurechlorid und einem tertiären Amin in einem geeigneten Lösungsmittel auf eine Temperatur ≥ 80°C erhitzt wird und
(b) das dabei erhaltene Reaktionsgemisch bei einer Temperatur < 80°C mit einer Lösung des Bis-o-aminophenols zur Reaktion gebracht wird.

Die Erfindung löst das vorstehend geschilderte Problem durch ein vereinfachtes Verfahren, nämlich ein Eintopfverfahren. Dabei wird die Dicarbonsäure zunächst mit einem Sulfonsäurechlorid und einer Base - in einem geeigneten Lösungsmittel - mindestens auf eine Temperatur von 80°C und vorzugsweise auf eine Temperatur ≥ 110°C erhitzt, vorteilhaft für die Dauer von 30 bis 120 min. Das dabei erhaltene Reaktionsgemisch wird dann bei einer Temperatur unterhalb von 80°C, vorzugsweise bei einer Temperatur von 0 bis 30°C, mit einer Lösung des Bis-o-aminophenols zur Reaktion gebracht. Dieses Verfahren zeigt eine hohe Selektivität der Amidbildung gegenüber der Esterbildung. Für die Selektivität ist es dabei wichtig, daß zuerst bei hohen Temperaturen (Verfahrensschritt a) und dann bei niederen Temperaturen (Verfahrensschritt b) gearbeitet wird. Ohne Einfluß ist, ob beim Verfahrensschritt (b) die Lösung des Bis-o-aminophenols zu dem die Dicarbonsäure enthaltenden Reaktionsgemisch gegeben wird oder umgekehrt.

Das Sulfonsäurechlorid ist vorzugsweise ein Toluolsulfonsäurechlorid, insbesondere p-Toluolsulfonsäurechlorid. Es können aber auch andere Sulfonsäurechloride eingesetzt werden, und zwar aromatische oder aliphatische Sulfonsäurechloride, beispielsweise Benzolsulfonsäurechlorid und Methansulfonsäurechlorid. Das tertiäre Amin, d.h. die Base, ist vorzugsweise Pyridin oder Triethylamin. Weitere mögliche Basen sind heterocyclische tertiäre Stickstoffverbindungen, wie Chinolin, und aliphatische tertiäre Amine, wie Methyldiethylamin, sowie aliphatisch-aromatische tertiäre Amine, wie N,N-Dimethylanilin. Als Lösungsmittel, und zwar sowohl für die Dicarbonsäure als auch für das Bis-o-aminophenol, d.h. für beide Verfahrensschritte, dient vorzugsweise N-Methylpyrrolidon oder N,N-Dimethylacetamid. Daneben kann beispielsweise auch γ-Butyrolacton Verwendung finden.

Beim Verfahren nach der Erfindung können die Dicarbonsäure und das Bis-o-aminophenol im molaren Verhältnis von etwa 1:1 eingesetzt werden. Bei einem Überschuß an Bis-o-aminophenol können die Aminoendgruppen des hergestellten Poly-o-hydroxyamids mit einem Dicarbonsäureanhydrid verkappt, d.h. blockiert werden. Hierzu eignet sich insbesondere cis-5-Norbornen-endo-2,3-dicarbonsäureanhydrid.

Aus der US-PS 3 637 601 ist ein Verfahren zur Herstellung von schwefelhaltigen Polyamiden und Polyestern bekannt, mit dem die Färbbarkeit verbessert werden soll. Dieses Verfahren ist jedoch zur Herstellung alkalilöslicher Poly-o-hydroxyamide nicht geeignet, wie die nachfolgend beschriebenen Vergleichsversuche zeigen. Außerdem sind schwefelhaltige Polymere - im Gegensatz zu den Polymeren nach der Erfindung, die keinen Schwefel enthalten - als Beschichtungen in der Mikroelektronik ungeeignet, weil sie einerseits Korrosion verursachen können und andererseits in reduzierenden Medien, wie sie bei der Halbleiterherstellung vorkommen, zu Kontaktbelagen führen können und dadurch die Zuverlässigkeit der elektrischen Kontaktierungen beeinträchtigen.

Anhand von Ausführungsbeispielen soll die Erfindung noch näher erläutert werden.

### Beispiel 1

Zu einer Lösung von 4,65 g Diphenylether-4,4'-dicarbonsäure in 40 ml N-Methylpyrrolidon wird unter Rühren eine Lösung von 7,54 g p-Toluolsulfonsäurechlorid und 7,05 g Pyridin in 70 ml N-Methylpyrrolidon gegeben. Das dabei entstandene Gemisch wird 30 min bei Raumtemperatur (ca. 21 ± 4°C) gerührt und anschließend 30 min auf eine Temperatur von etwa 120°C erhitzt; danach läßt man unter Rühren auf Raumtemperatur abkühlen. Zu dem dabei erhaltenen Reaktionsgemisch wird bei Raumtemperatur unter Rühren eine Lösung getropft, die durch Auflösen von 7,33 g Hexafluor-2,2-bis-(4-hydroxy-3-aminophenyl)-propan in 90 ml N-Methylpyrrolidon bei Raumtemperatur unter Rühren hergestellt worden ist. Die dabei erhaltene Reaktionslösung läßt man 20 h bei Raumtemperatur abreagieren.

Anschließend werden die Endgruppen blockiert, wobei zur Reaktionslösung bei Raumtemperatur innerhalb von 15 min eine Lösung von 1,48 g cis-5-Norbornen-endo-2,3-dicarbonsäureanhydrid in 10 ml N-Methylpyrrolidon getropft und dann bei Raumtemperatur 20 h gerührt wird. Die dabei erhaltene Reaktionslösung wird abfiltriert und das entstandene Poly-o-hydroxyamid mit 1500 ml eines Gemisches aus Isopropanol und Wasser ausgefällt. Der Niederschlag wird abfiltriert, zweimal mit je 400 ml Wasser gewaschen und im Vakuumschrank bei 60°C getrocknet. Die Verkappung der Endgruppen übt keinen Einfluß auf die Polymerisation aus, sie wird nur durchgeführt, um insbesondere die thermische Formbeständigkeit des Polymers während der Cyclisierung durch eine Vernetzung zu verbessern; die Verkappung kann deshalb auch unterbleiben.

Das IR-Spektrum des Poly-o-hydroxyamids zeigt eindeutig nur Amidbanden, aber keine Esterbande. Die Elementaranalyse des Polymers ergibt die theoretischen Werte, d.h. 58,24 % Kohlenstoff, 3,76 % Wasserstoff und 4,73 % Stickstoff; Schwefel ist nicht nachweisbar.

Das Poly-o-hydroxyamid ist in kommerziellen wäßrig-alkalischen, metallionenfreien Entwicklern klar löslich. Zur Herstellung von Filmen werden 2,5 g des Poly-o-hydroxyamids in 7,5 g N-Methylpyrrolidon gelöst, die entstandene Lösung wird dann durch ein 1 µm-Filter filtriert und mittels Schleudertechnik auf einen Siliciumwafer aufgebracht. Nach dem Trocknen auf einer Heizplatte bei 115°C wird auf dem Wafer ein gleichmäßiger fehlerfreier Polymerfilm mit einer Schichtdicke von 1500 nm erhalten.

### Beispiel 2

Wird ein entsprechend Beispiel 1 hergestelltes Reaktionsgemisch - bei Raumtemperatur und unter Rühren - zu der dort beschriebenen Lösung des Bis-o-aminophenols getropft und entsprechend weiterbehandelt , so wird ein Poly-o-hydroxyamid erhalten, das die gleichen Eigenschaften (Elementaranalyse, Alkalilöslichkeit, Filmbildung) aufweist wie das Poly-o-hydroxyamid nach Beispiel 1.

### Beispiel 3 (Vergleichsversuch)

Es wird entsprechend Beispiel 1 vorgegangen, jedoch mit dem Unterschied, daß die Lösung des Bis-o-aminophenols zum Reaktionsgemisch bei einer Temperatur von 100°C zugetropft und zur Reaktion gebracht wird. Das IR-Spektrum des dabei erhaltenen Polymers zeigt neben den Amidbanden auch eine deutliche Esterbande. Dieses Polymer ist außerdem in wäßrig-alkalischen, metallionenfreien Entwicklern nicht löslich.

### Beispiel 4 (Vergleichsversuch)

Es wird entsprechend Beispiel 1 vorgegangen, jedoch mit dem Unterschied, daß zur Herstellung des Reaktionsgemisches nicht auf eine Temperatur von 120°C erhitzt wird, sondern lediglich 60 min bei Raumtemperatur gerührt wird. Das IR-Spektrum des dabei erhaltenen Produktes zeigt neben schwachen Amidbanden deutliche Banden der Ausgangsverbindungen. Bei der Filmbildung wird festgestellt, daß nach dem Trocknen bei 115°C ein ungleichmäßiger Film mit vielen größeren Defektstellen vorliegt, dessen Dicke nur 500 bis 700 nm beträgt. Dieses Produkt ist deshalb für mikroelektronische Anwendungen nicht geeignet.

## Patentansprüche

1. Verfahren zur Herstellung von Poly-o-hydroxyamiden durch Umsetzung einer Dicarbonsäure mit einem Bis-o-aminophenol, **dadurch gekennzeichnet**, daß
(a) die Dicarbonsäure zusammen mit einem Sulfonsäurechlorid und einem tertiären Amin in einem geeigneten Lösungsmittel auf eine Temperatur ≥ 80°C erhitzt wird und
(b) das dabei erhaltene Reaktionsgemisch bei einer Temperatur < 80°C mit einer Lösung des Bis-o-aminophenols zur Reaktion gebracht wird.

2. Verfahren nach Anspruch 1, **dadurch gekennzeichnet**, daß Toluolsulfonsäurechlorid eingesetzt wird.

3. Verfahren nach Anspruch 1 oder 2, **dadurch gekennzeichnet**, daß bei (a) auf eine Temperatur ≥ 110°C erhitzt wird.

4. Verfahren nach einem der Ansprüche 1 bis 3, **dadurch gekennzeichnet**, daß bei (a) für die Dauer von 30 bis 120 min erhitzt wird.

5. Verfahren nach einem oder mehreren der Ansprüche 1 bis 4, **dadurch gekennzeichnet**, daß bei (b) die Reaktion bei einer Temperatur von 0 bis 30°C durchgeführt wird.

6. Verfahren nach einem oder mehreren der Ansprüche 1 bis 5, **dadurch gekennzeichnet**, daß das tertiäre Amin Pyridin oder Triethylamin ist.

7. Verfahren nach einem oder mehreren der Ansprüche 1 bis 6, **dadurch gekennzeichnet**, daß als Lösungsmittel N-Methylpyrrolidon oder N,N-Dimethylacetamid verwendet wird.

8. Verfahren nach einem oder mehreren der Ansprüche 1 bis 7, **dadurch gekennzeichnet**, daß Aminoendgruppen mit einem Dicarbonsäureanhydrid verkappt werden.

## Claims

1. Method for the preparation of poly-o-hydroxyamides by converting a dicarboxylic acid with a bis-o-aminophenol, characterised in that
(a) the dicarboxylic acid is heated to a temperature of ≥ 80°C together with a sulphonic acid chloride and a tertiary amine in a suitable solvent; and
(b) the reaction mixture thereby obtained is reacted with a solution of the bis-o-aminophenol at a temperature of < 80°C.

2. Method according to claim 1, characterised in that toluene sulphonic acid chloride is used.

3. Method according to claim 1 or 2, characterised in that in step (a) heating is effected to a temperature of ≥ 110°C.

4. Method according to one of claims 1 to 3, characterised in that in step (a) heating is effected for a period of 30 to 120 minutes.

5. Method according to one or more of claims 1 to 4, characterised in that in step (b) the reaction is carried out at a temperature of 0 to 30°C.

6. Method according to one or more of claims 1 to 5, characterised in that the tertiary amine is pyridine or triethylamine.

7. Method according to one or more of claims 1 to 6, characterised in that N-methyl pyrrolidone or N,N-dimethyl acetamide is used as the solvent.

8. Method according to one or more of claims 1 to 7, characterised in that amino end groups are capped with a dicarboxylic acid anhydride.

## Revendications

1. Procédé de préparation de poly-o-hydroxyamides par réaction d'un acide dicarboxylique avec un bis-o-aminophénol, caractérisé
(a) en ce que l'acide dicarboxylique est chauffé ensemble avec un chlorure d'acide sulfonique et une amine tertiaire dans un solvant approprié à une température ≥ 80 °C et
(b) en ce que le mélange réactionnel résultant est mis à réagir à une température < 80 °C avec une solution du bis-o-aminophénol.

2. Procédé selon la revendication 1, caractérisé en ce qu'on utilise du chlorure d'acide toluènesulfonique.

3. Procédé selon la revendication 1 ou 2, caractérisé en ce qu'on chauffe à l'étape (a) à une température ≥ 110 °C.

4. Procédé selon l'une des revendications 1 à 3, caractérisé en ce qu'on chauffe à l'étape (a) pendant une durée de 30 à 120 min.

5. Procédé selon une ou plusieurs des revendications 1 à 4, caractérisé en ce qu'on effectue à l'étape (b) la réaction à une température de 0 à 30 °C.

6. Procédé selon une ou plusieurs des revendications 1 à 5, caractérisé en ce que l'amine tertiaire est la pyridine ou la triéthylamine.

7. Procédé selon une ou plusieurs des revendications 1 à 6, caractérisé en ce qu'on utilise à titre de solvant de la N-méthylpyrrolidone ou du N,N-diméthylacétamide.

8. Procédé selon une ou plusieurs des revendications 1 à 7, caractérisé en ce que les groupes amino terminaux sont bloqués par un anhydride d'acide dicarboxylique.
